# EUROPEAN PATENT APPLICATION

(11) **EP 4 528 805 A1**
(43) Date of publication of application: **26.03.2025**
(21) Application number: 23199079.7
(22) Date of filing: 22.09.2023
(51) Int. Cl.: H01L 23/48

(54) **ELECTRONIC COMPONENT AND METHOD FOR CLEANING BONDING TOOL**

(71) Applicant: Murata Manufacturing Co., Ltd., Nagaokakyo-shi, Kyoto 617-8555 (JP)
(72) Inventor: NURMI, Sami, 04320 Tuusula (FI)
(74) Representative: Boco IP Oy Ab

(57) **Abstract**

An electronic component (1) comprises a package (7), at least one electronic chip (2) housed within an enclosure inside the package, and at least one first bonding pad (3), at least one second bonding pad (4), and at least one bond (5) connected to at least one bonding pad (3) and at least one second bonding pad (4) for establishing an electric connection between the electronic chip (2) and surrounding circuitry. A cleaning pad (6) is provided in the package (7). The cleaning pad (6) is spaced from first bonding pad(s) (3) and second bonding pad(s) (4), designed to be electrically disconnected from other structures or components, and designed to enable cleaning of a bonding tool (8).

## Description

### FIELD OF THE DISCLOSURE

The present disclosure relates to cleaning a bonding tool in connection with bonding of electronic components, and more particularly to an electronic component. The present disclosure further concerns a method for cleaning a bonding tool.

### BACKGROUND OF THE DISCLOSURE

Electronic chips, which may also be called dies, may be placed inside a protective package which forms an enclosure where the chip is protected from the surrounding environment. The chip may be mechanically attached to a support structure inside the enclosure, such as a die pad, and electrically connected to contacts which extend outside of the enclosure. The packaged chip thereby forms an electronic component which can be mounted on a circuit board.

Bonding pads are widely used in connection with electronic components for establishing the electrical connections. Bonding pads are used for instance in connection with MEMS components and similar devices. Bonding pads may serve as connection points for external electrical connections allowing transfer of electrical signals, power and data between the MEMS devices and the surrounding circuitry.

Bonding pads are typically made of conductive materials and placed to enable forming of bonds, such as wire bonds, by a bonding tool to connect the electronic component to the bonding pad and thereby to surrounding circuitry.

A problem with bonding tools is that the manufacturing process typically does not enable continuous use of the bonding tool, but there are short breaks due to the structure of the parts or the phases of the manufacturing process during which the bonding tool is not used for implementing wire bonds. Even very short breaks, such as breaks of a couple of seconds, may cause the bonding tool to cool down. Thereby, the first wire bonds implemented after such a break may be colder. In addition, cleaning of the bonding tool may be needed for instance due to contamination of the tool due to impurities in the surrounding air or for other causes.

### BRIEF DESCRIPTION OF THE DISCLOSURE

An object of the present disclosure is to provide a method and an electronic component.

The object of the disclosure is achieved by a method and an electronic component, which are characterized by what is stated in the independent claims. Some embodiments of the disclosure are disclosed in the dependent claims.

The disclosure is based on the idea of providing the electronic component with a cleaning pad.

An advantage of the method and electronic component of the disclosure is that the bonding tool may be cleaned on every electronic component in-situ on a cleaning site provided in the package structure. This may improve wire bonding process yield due to less downtime needed and improve quality.

### BRIEF DESCRIPTION OF THE DRAWINGS

In the following the disclosure will be described in greater detail by means of preferred embodiments with reference to the accompanying drawings, in which
Figure 1 illustrates schematically a part of an electronic component in cross section;
Figure 2 illustrates schematically an electronic component in cross section;
Figure 3 illustrates schematically a partly opened electronic component seen from above;
Figure 4 illustrates schematically a second partly opened electronic component seen from above;
Figure 5 illustrates schematically a third partly opened electronic component seen from above; and
Figure 6 illustrates schematically a method for cleaning a bonding tool.

### DETAILED DESCRIPTION OF THE DISCLOSURE

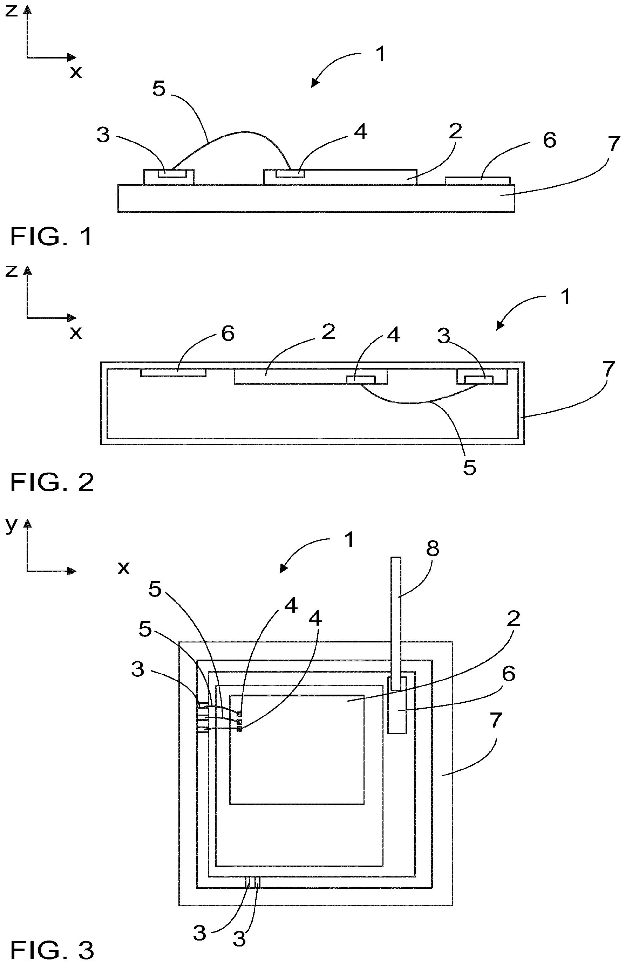

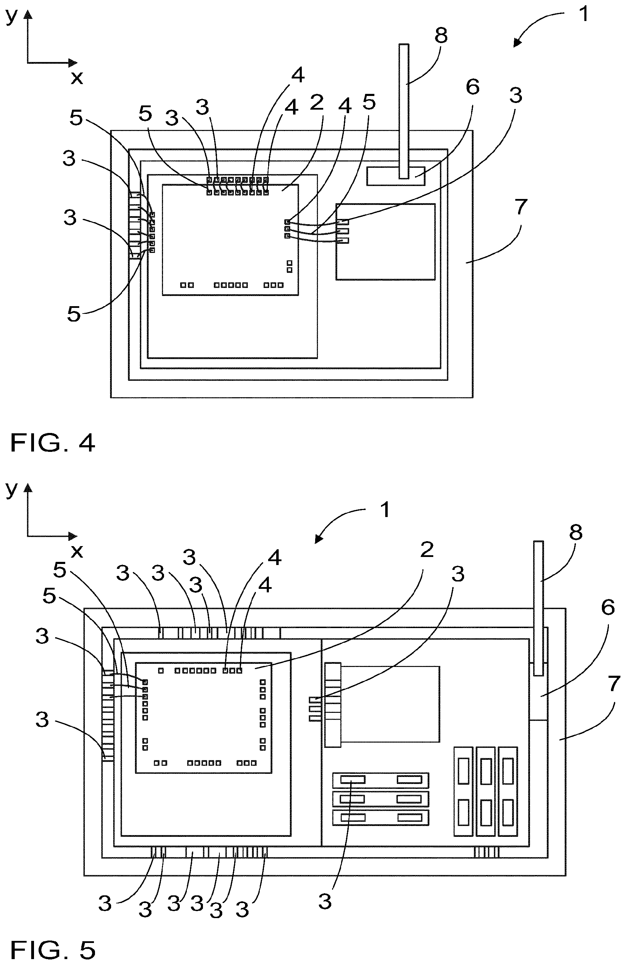

Figure 1 illustrates schematically a part of an electronic component in cross section; Figure 2 illustrates schematically an electronic component in cross section; Figure 3 illustrates schematically a partly opened electronic component seen from above; Figure 4 illustrates schematically a second partly opened electronic component seen from above; and Figure 5 illustrates schematically a third partly opened electronic component seen from above.

In the figures of this disclosure, the plane defined by the x- and y-axes is parallel to the plane of a printed circuit board (PCB), later called a circuit board in this disclosure, to which the electronic component is configured to be attached. The direction defined by the z-axis is perpendicular to the same plane of the circuit board, or a circuit board plane.

In this disclosure, the words "bottom" and "top" only refer to how the component is configured to be placed with respect to a circuit board (PCB). The bottom side of the component is configured to be attached to the surface of the circuit board. Words such as "above" and "below" are used with the same meaning: a first part which is below a second part is configured to be closer to the circuit board, and the second part is provided on the top side of the component with respect to the first part. Words such as "bottom" and "top", "above" and "below", thus, do not refer to the orientation of the component with regard to the direction of earth's gravitational field either when the component is manufactured or when it is in use, although they can in some cases be in agreement with this conventional meaning of top / bottom when the xy-plane is horizontal.

Referring to the axes indicated in the figures, Figure 1 shows schematically an embodiment of the electronic component, more particularly a part of an electronic component, in the direction of y-axis in cross section, Figure 2 shows schematically an embodiment of the electronic component in the direction of y-axis in cross section, and Figures 3-5 show schematically different embodiments of the electronic component partly opened, in other words with some parts of the electronic component not in place / not shown in the figures, in the direction of the z-axis, which direction is also called "from above" in this disclosure.

The electronic component 1 comprises a package 7 and at least one electronic chip 2, also called a chip 2 in this disclosure, housed within an enclosure inside the package 7. The package 7 may comprise a top, a bottom, and four sides: first side, second side, third side and a fourth side. The enclosure may then be formed withing the top, the bottom, and the four sides. Figure 2 illustrates schematically an embodiment of an electronic component 1 showing such a package in cross section, whereas Figures 1 and 3-5 shown embodiments of an electronic component 1 in cross section and/or with a part of the package 7 not shown to better illustrate parts of the electronic component 1 provided inside the package 7.

In the electronic component 1, the electronic chip 2 is housed within the package 7. The package 7 provides protection for the electronic chip(s) 2 inside the electronic component 1. According to an embodiment, the package 7 may be made of one material. According to another embodiment, the package 7 may comprise multiple materials, for instance some part(s) of the package 7 may be made of one material and some other part(s) of the package 7 from another material. According to an embodiment, at least a part of the package 7, such as the area of the package 7 on which the electronic chip 2 is provided and the area immediately surrounding the electronic chip 2, as shown by a rectangle around the electronic chip 2 in Figures 3-5, may be gold-plated or formed of ceramic material.

According to an embodiment, the electronic component 1, more particularly the package 7, may comprise a package base and a cap (not shown). In such embodiments, Figures 1 - 5 may illustrate schematically a package base, or a part of the package base for instance in Figure 1, with the electronic chip 2 and possible other parts and devices before a cap is attached to the package base. In other embodiments, the Figures 1 - 5 may illustrate details of electronic components 1, where a portion of the electronic component 1 is not shown for illustrative purposes. It should also be understood that the figures are provided for illustrative purposes, and electronic components 1 may comprise further parts not shown in the figures.

The package base and the cap may together form the enclosure. According to an embodiment, the cap may form the bottom side of the package 7. According to an embodiment, the cap may be made of a material different from the material of the rest of the package 7. According to an embodiment, the package 7 may comprise at least one of the following: a plastic material, a metal material, or a ceramic material. According to an embodiment, the metal material may comprise stainless steel, copper, or nickel-cobalt ferrous alloy, such as Kovar. According to an embodiment, the cap may comprise at least one of the following: a metal material or a ceramic material.

According to an embodiment, the package base may for instance be made of plastic. According to an embodiment, the package base may be manufactured in a moulding process where the package base is moulded around a leadframe, where a chip mounting element (not shown) and electronic leads have been formed. Other methods can also be used to form a plastic package base. The package base may alternatively be made of a ceramic material. The cap can be attached to the package base with glue or with any other method. The attachment region where the cap is attached to the package base may encircle the enclosure.

According to an embodiment, the electronic component 1 may comprise a single case component. In this disclosure, a single case component refers to a discrete electronic device that is enclosed within a single package or housing. In other words, all necessary elements and connections for the component to function are contained within the single package. Such single components may for instance be mounted on a circuit board or used individually depending on the application. The disclosed solution, namely the disclosed structure of an electronic component 1 and the method for cleaning a bonding tool 8, may be particularly beneficial in connection with single case components, since they do not comprise internal structures, such as lead frame feet or suitable free space, that could be used for cleaning the bonding tool 8.

According to an embodiment, the electronic component 1 may comprise a MEMS component. According to an embodiment, the electronic chip 2 may comprise at least one of the following: an accelerometer configured to measure acceleration, a gyroscope configured to measure angular rotation, or a magnetometer. The accelerometer or gyroscope may be a MEMS accelerometer / gyroscope. According to an embodiment, the electronic chip 2 comprises another type of an orientation-sensitive chip.

The electronic component 1 further comprises at least one first bonding pad 3, at least one second bonding pad 4, and at least one bond 5 connected to at least one first bonding pad 3 and at least one second bonding pad 4 for establishing an electric connection between the electronic chip 2 and surrounding circuitry. In other words, the bond 5 may electrically connect the first bonding pad 3 and the second bonding pad 4. One of the bonding pads, for instance second bonding pad 4, may be, directly or indirectly, electrically connected to the electronic chip 2, whereby the first bonding pad 3, the second bonding pad 4, and the bond 5 may provide an electric connection between the electronic chip 2 and surrounding circuitry. The second bonding pad 4 being directly electrically connected to the electronic chip 2 refers to the second bonding pad 4 being attached to the electronic chip 2. The second bonding pad 4 being indirectly electrically connected to the electronic chip 2 refers to the second bonding pad 4 being connected to the electronic chip 2 via a further electrically conductive part or structure.

According to an embodiment, the first bonding pad(s) 3 may be provided in the package 7 or other part(s) of the electronic component 1. In other words, the first bonding pad(s) 3 may be provided on an inner surface of the package 7 or other parts(s) of the electronic component 1 provided inside the package 7. More particularly, the first bonding pad(s) 3 may be provided within the enclosure. Different ways of positioning the first bonding pads 3 are shown in Figures 1 - 5. According to an embodiment, at least one first bonding pad 3 may be provided in the package 7. According to an embodiment, at least one first bonding pad 3 may be, directly or indirectly, electrically connected to an electronic lead of the electronic component 1. According to an embodiment, a part of an electronic lead of the electronic component 1 may form the first bonding pad 3.

The electronic component 1 further comprises a cleaning pad 6. The cleaning pad 6 is provided in the package 7. In other words, the cleaning pad 6 is provided inside the package 7. More particularly, the cleaning pad 6 may, thus, be enclosed within the enclosure in the electronic component 1, when the electronic component 1 is manufactured and ready to be used and/or installed.

The cleaning pad 6 is spaced from first bonding pad(s) 3 and second bonding pad(s) 4. In other words, the cleaning pad 6 is separate from the first bonding pads 3 and second bonding pads 4. According to an embodiment, the cleaning pad 6 may be provided on an inner surface of the package 7, such as best illustrated in Figure 2. According to an embodiment, the cleaning pad 6 may be provided on another part of the electronic component 1 provided inside the package 7.

The cleaning pad 6 may be designed to be electrically disconnected from other structures or components. In other words, the cleaning pad 6 is not intended to be electrically connected to other parts of the electronic component 1 or surrounding circuitry, for instance to be connected to other parts of the electronic component 1 or surrounding circuitry by a bond 5.

According to an embodiment, the bond 5 may comprise a wire bond. The disclosed solution, namely the electronic component 1 and the method of cleaning a bonding tool 8, may be particularly useful in connection with wire bonding and wire bonds. According to an embodiment, the bond 5 may comprise a gold wire, a copper wire, an aluminium wire, a silver wire, a wire comprising a combination of these materials, or a wire plated with one of these materials or a with a material comprising a combination of these materials.

The cleaning pad 6 may also be designed to enable cleaning of a bonding tool 8. A bonding tool 8, is a tool used for creating bonds 5 between bonding pads, for instance between first bonding pads 3 and second bonding pads 4. According to an embodiment, the bonding tool 8 may comprise a wire bond capillary, also called bonding capillary. Such a bonding tool 8 may be configured to create wire bonds between the bonding pads. According to an embodiment, the bonding tool 8 may comprise a bonding tool of a wire bonder machine. According to an embodiment, the bonding tool 8 may be configured to hold and manipulate a bonding wire during a wire bonding process. A tip of the bonding tool 8 may be configured to guide the bonding wire and bond it to the bonding pad(s) 3, 4.

According to an embodiment, the cleaning pad 6 is designed to enable cleaning of the bonding tool 8 by forming at least one bond 5 on the cleaning pad 6. According to an embodiment, the at least one bond 5 formed for cleaning the bonding tool 8 only extends within the area of the cleaning pad 6. In other words, the at least one bond 5 formed for cleaning the bonding tool 8 does not connect the cleaning pad 6 electrically to any further parts of the electronic component 1 or surrounding circuitry.

According to an embodiment, the cleaning pad 6 is made of a process compatible material, which is called a wire bondable material in this disclosure. According to an embodiment, the cleaning pad 6 is made of made of gold, nickel, silver, copper, cobalt, aluminium, tungsten, titanium, or a combination thereof. According to an embodiment, one or more of the first bonding pad(s) 3, the second bonding pad(s) 4, and the cleaning pad 6 are made of a same material, such as gold, nickel, silver, copper, cobalt, aluminium, tungsten, titanium, or a combination thereof.

According to an embodiment, the surface area of the cleaning pad 6 is at least two times as large as the surface area of the smallest bonding pad 3, 4. According to an embodiment, the surface area of the cleaning pad 6 is at least two times as large as the surface area of the largest bonding pad 3, 4. In other words, the surface of the cleaning pad 6 may be clearly larger, for instance at least twice as large, as the surface of the first bonding pad(s) 3 and the second bonding pad(s) 4. Thereby, more than one bonds 5 may be provided on the cleaning pad 6.

According to an embodiment, as referred to, the package 2 may further comprise a plurality of electronic leads (not shown) protruding from the package 7 and configured to extend from at least two sides, preferably from at least two opposite sides, of the package, such as the second side and the fourth side of the package 7. According to an embodiment, the electronic leads may be configured to protrude from the package 7 at least in a direction corresponding to a downward direction. According to an embodiment, the electronic leads may further be configured to extend outwards from the package 7, for instance in a bended manner.

According to an embodiment, the electronic leads may be used to establish electric connections from the surrounding circuitry to the electronic chip(s) 2. In other words, the electronic chip(s) 2 may be connected to the electronic leads inside the package 7, for example by wire bonding or flip chip bonding (not shown), and the electronic leads may extend outward from the package 7 in a side direction which is substantially perpendicular to the z-axis. Electric connections to the electronic chip(s) 2 can then be made by connecting the electronic leads to suitable connectors.

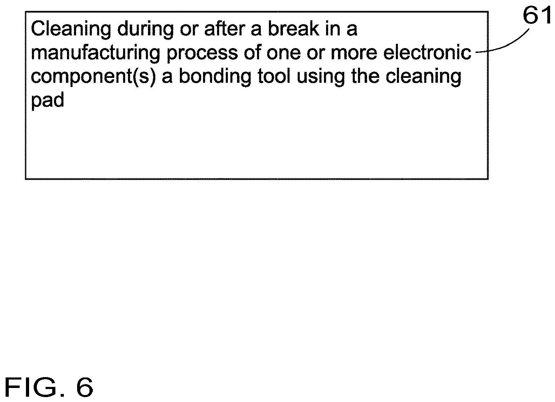

Figure 6 illustrates schematically a method for cleaning a bonding tool.

A method for cleaning a bonding tool, such as the method of Figure 6, may comprise cleaning 61 a bonding tool 8 during or after a break in a manufacturing process of one or more electronic component(s) 1 using the cleaning pad 6. The electronic component 1 may comprise an electronic component 1 according to an embodiment disclosed in this description and/or accompanying claims and drawings, or a combination of such embodiments.

In the manufacturing process of one or more electronic components 1, a break may comprise for instance a break caused by the structure of the electronic component 1 or a phase of the manufacturing process. For instance, the electronic component 1 processed may change, the position of the electronic component 1 may need to be changed, or some other intermediate phase of the process may be necessary thus causing a break in the forming of the bonds 5. This may cause the electronic component 1 to cool down, which may affect the quality of the first bonds 5 formed after the break. In the method of this disclosure, and the method of Figure 6, thus, the bonding tool 8 may be cleaned during such a break or immediately after the break before forming first actual bond 5, which is a bond designed to establish an electric connection between the electronic chip 2 and the surrounding circuitry, to the electronic component 1.

According to an embodiment, the cleaning of the bonding tool 8 comprises forming at least one bond 5 on the cleaning pad 6. According to an embodiment, the bond 5 may only extend within the area of the cleaning pad 6, as explained in connection with electronic component embodiments. According to an embodiment, the bond 5 may be a wire bond.

## Claims

1. An electronic component, which electronic component comprises
a package,
at least one electronic chip housed within an enclosure inside the package, and
at least one first bonding pad, at least one second bonding pad, and at least one bond connected to at least one bonding pad and at least one second bonding pad for establishing an electric connection between the electronic chip and surrounding circuitry, **characterized in that**
a cleaning pad is provided in the package, which cleaning pad is spaced from first bonding pad(s) and second bonding pad(s), designed to be electrically disconnected from other structures or components, and designed to enable cleaning of a bonding tool.

2. An electronic component according to claim 1, wherein the cleaning pad is made of a wire bondable material.

3. An electronic component according to claim 1 or 2, wherein the cleaning pad is made of made of gold, nickel, silver, copper, cobalt, aluminium, tungsten, titanium, or a combination thereof.

4. An electronic component according to claim 3, wherein the first bonding pad(s), the second bonding pad(s), and the cleaning pad are made of gold, nickel, silver, copper, cobalt, aluminium, tungsten, titanium, or a combination thereof.

5. An electronic component according to any one claims 1 - 4, wherein the bond comprises a wire bond.

6. An electronic component according to any one of claims 1 - 5, wherein the cleaning pad is designed to enable cleaning of the bonding tool by forming at least one bond on the cleaning pad, which bond only extends within the area of the cleaning pad.

7. An electronic component according to any one of claims 1 - 6, wherein the surface area of the cleaning pad is at least two times as large as the surface area of the smallest bonding pad.

8. An electronic component according to claim 7, wherein the surface area of the cleaning pad is at least two times as large as the surface area of the largest bonding pad.

9. An electronic component according to any one of claims 1 - 8, wherein the electronic component comprises a single case component.

10. A method for cleaning a bonding tool, **characterized in that** the method comprises cleaning, during or after a break in a manufacturing process of one or more electronic component(s) according to any one of claims 1 - 9, a bonding tool using the cleaning pad.

11. A method according to claim 10, wherein the cleaning of the bonding tool comprises forming at least one bond on the cleaning pad, which bond only extends within the area of the cleaning pad.

12. A method according to claim 11, wherein the bond is a wire bond.
